# EUROPÄISCHE PATENTSCHRIFT

(11) **EP 1 110 317 B1**
(45) Veröffentlichungstag und Bekanntmachung des Hinweises auf die Patenterteilung: **07.08.2002**
(21) Anmeldenummer: 99953682.4
(22) Anmeldetag: 01.09.1999
(51) Int. Cl.: H03J 5/24

(54) **RUNDFUNKEMPFANGSGERÄT**
RADIO RECEIVER EQUIPMENT
APPAREIL DE RECEPTION RADIO

(30) Priorität: 02.09.1998 DE 19839857
(43) Veröffentlichungstag der Anmeldung: 27.06.2001
(73) Patentinhaber: ROBERT BOSCH GMBH, 70442 Stuttgart (DE)
(72) Erfinder: RITSCHEN, Andreas, D-21385 Amelinghausen (DE); WITTIG, Rainer, D-31249 Hohenhameln (DE)
(86) Internationale Anmeldenummer: DE9902769
(87) Internationale Veröffentlichungsnummer: WO0014872

(56) Entgegenhaltungen:
- DE-A- 3 939 709
- GB-A- 1 190 459
- GB-A- 2 143 693
- US-A- 4 152 652
- US-A- 5 483 209
- PATENT ABSTRACTS OF JAPAN vol. 009, no. 165 (E-327), 10. Juli 1985 (1985-07-10) & JP 60 041330 A (MATSUSHITA DENKI SANGYO KK), 5. März 1985 (1985-03-05)

## Beschreibung

Die Erfindung betrifft ein Rundfunkempfangsgerät mit einem an eine Empfangsantenne angeschlossenen, einer mit einem Abstimmsignal durchstimmbaren Abstimmstufe, einer Frequenzumsetzerstufe mit einem durch das Abstimmsignal steuerbaren Mischoszillator zur Umsetzung der empfangenen Hochfrequenzsignale in eine definierte Zwischenfrequenzlage und mit Weiterverarbeitungsstufen zur Bildung eines hörbaren Niederfrequenzsignals.

Mit diesem prinzipiellen Aufbau werden Rundfunkempfangsgeräte seit vielen Jahren ausgerüstet. Die jeweilige Abstimmstufe ist so dimensioniert, daß die Durchstimmung mit Hilfe des Abstimmsignals über einen in Frage kommenden Empfangsbereich ermöglicht wird. In entsprechender Weise ist der Mischoszillator der Frequenzumsetzerstufe durchstimmbar, um die mit der Abstimmstufe selektierte Hochfrequenz in die im Rundfunkempfangsgerät definierte Zwischenfrequenz umzusetzen. Zur Erzielung guter Abstimmeigenschften werden dabei bevorzugt Abstimmstufen verwendet, die aus einem ersten durchstimmbaren Abstimmkreis, einer Verstärkerstufe und einem zweiten durchstimmbaren Abstimmkreis bestehen.

Da in verschiedenen Ländern verschiedene Empfangsbereiche, beispielsweise für den UKW-Empfang, freigegeben sind, ist es erforderlich, die Rundfunkempfangsgeräte für die betroffenen Länder als verschiedene Typen auszubilden, um eine optimale Anpassung der verwendeten Abstimmstufen an das in dem betreffenden Land verwendete Frequenzband zu ermöglichen. Dies führt zu der Notwendigkeit der Lagerhaltung für getrennte Rundfunkempfangsgerätetypen. Bei Autoradios entsteht der weitere Nachteil, dass beim Verbringen des betreffenden Autos in ein entsprechendes anderes Land ein Rundfunkempfang mit dem eingebauten Autoradio ohne dessen Veränderung nur noch teilweise oder überhaupt nicht mehr möglich ist.

Beispielsweise liegt das Frequenzband für einen UKW-Empfang in den europäischen Staaten zwischen 87,5 und 108 MHz, während das vergleichbare Frequenzband in Japan zwischen 76 und 90 MHz liegt. Es ist erkennbar, dass ein für Europa vorgesehener Empfänger in Japan nur noch einen kleinen Randbereich des dort verwendeten Frequenzbandes empfangen kann.

Die an sich denkbare breitere Auslegung der Abstimmstufe zur Abdeckung des gesamten in Frage kommenden Frequenzbandes zwischen 76 und 108 MHz wäre mit vertretbarem Aufwand für den Abstimmkreis nur zu Lasten der Abstimmeigenschaften der Abstimmstufe möglich und kommt daher nicht in Betracht.

Der Erfindung liegt daher die Problemstellung zugrunde, ein Rundfunkempfangsgerät der eingangs erwähnten Art so auszubilden, dass der Empfang gleichartiger Rundfunksignale, insbesondere UKW-Signale in verschiedenen Bändern mit voneinander verschiedenen, sich im allgemeinen überlappenden Bandgrenzen ohne eine Einbuße der Abstimmeigenschaften der Abstimmstufe möglich ist.

GB-A-1 190 459 offenbart einen Rundfunkempfänger mit getrennten, an einer Antenne angeschlossenen Abstimmstufen für verschiedene Frequenzbereiche und einem Frequenzumsetzer mit einem Mischer zur Herabmischung der empfangenen Rundfunksignale. Dafür sind zwei getrennte Oszillatoren vorgesehen, von denen wahlweise einer zur Herabmischung eines mit der zugehörigen Abstimmstufe empfangenen Hochfrequenzsignals verwendet wird.

Limann, Pelka: Funktechnik ohne Balast, Franzis-Verlag, München, 1984, Seiten 343, 344 offenbart einen Mehrbandempfänger zum Empfang von LW-, MW- und KW-AM-Signalen, wobei ein gemeinsamer Oszilator für die drei Frequenzbänder vorgesehen ist, dessen Brückstimmbereich bandabhängig schaltbar ist. Zum Empfang der Signale aller drei Frequenzbänder ist eine gemeinsame Vorstufe vorgesehen.

US-A-4152652 offenbart einen Hochfrequenzempfänger, wobei zwei Oszillatoren vorhanden sind, die oberhalb bzw. unterhalb der Empfangsfrequenz schwingen.

Ausgehend von oben genannter Problemstellung ist die Erfindung gerichtet auf ein Rundfunkempfangsgerät mit mindestens zwei an eine Empfangsantenne angeschlossenen, separat wirksam schaltbaren, durchstimmbaren Abstimmstufen für zwei Empfangsbereiche, mit einem Umschalter zur wahlweisen Verbindung einer der Abstimmstufen mit einer Frequenzumsetzerstufe, mit einem Mischoszillator zur Umsetzung empfangener Hochfrequenzsignale in eine definierte Zwischenfrequenz, wobei der Mischoszillator mit einer Umschaltung auf eine der Abstimmstufen in seinen Abstimmbereich derart umschaltbar ist, dass seine Schwingfrequenz für einen ersten Empfangsbereich der ersten Abstimmstufe um eine Zwischenfrequenz oberhalb der zu empfangenden Frequenz und für einen zweiten Empfangsbereich der zweiten Abstimmstufe um die Zwischenfrequenz unterhalb der zu empfangenden Frequenz eingestellt wird.

Durch diese Wahl der Frequenzlagen des Mischoszillators können Störeinflüsse durch die Oszillatorfrequenzen verringert werden.

Das erfindungsgemäße Rundfunkempfangsgerät ist somit ein Mehrnormen-Empfangsgerät, das insbesondere UKW-Rundfunksendungen in Bändern mit unterschiedlichen Bandgrenzen empfangen kann. Für die betroffenen Bänder mit den unterschiedlichen Bandgrenzen sind wenigstens zwei parallele Abstimmeinheiten vorgesehen, die separat wirksam schaltbar sind, so dass eine Rückwirkung auf die jeweils andere Abstimmeinheit unterbindbar ist.

Mit der Auswahl des wirksamen Abstimmeinheit wird eine entsprechende Umschaltung des Mischoszillators in der Frequenzumsetzerstufe vorgenommen. Hierzu ist der Mischoszillator zweckmäßigerweise mit einer Anzapfung versehen, die zum Zwecke der Umschaltung wirksam oder unwirksam geschaltet werden kann.

Die Erfindung ermöglicht somit den Betrieb des Rundfunkempfangsgeräts in verschiedenen Ländern, in denen unterschiedliche Bandgrenzen für den Empfang von Rundfunksignalen einer bestimmten Art, beispielsweise UKW-Rundfunksignalen festgelegt sind. Selbstverständlich ist die Erfindung auch für unterschiedliche Bandgrenzen im Mittelwellen-, Kurzwellen- oder Langwellenbereich anwendbar.

In einer besonders zweckmäßigen Ausführungsform der Erfindung ist die Empfangsantenne jeweils über einen Koppelkondensator und einen Schalter nur für die über den Umschalter mit der Frequenzumsetzstufe verbundenen Abstimmheit wirksam schaltbar. Die jeweils nicht verwendete Abstimmeinheit wird durch den mit Masse verbindbaren Koppelkondensator von der Empfangsantenne abgeschaltet. Durch die Dimensionierung der Koppelkondensatoren kann gewährleistet werden, dass der abgeschaltete Abstimmkreis den eingeschalteten Abstimmkreis nicht beeinflußt.

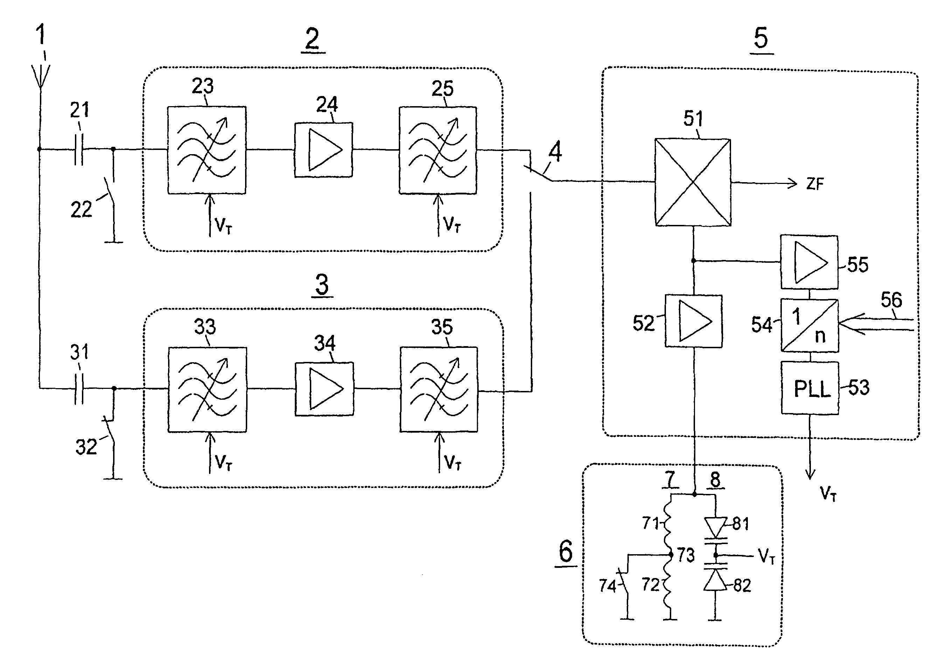

Die Erfindung soll im folgenden anhand eines in der Zeichnung dargestellten Ausführungsbeispiels näher erläutert werden.

Die Zeichnung zeigt eine schematische Darstellung der für das erfindungsgemäße Rundfunkempfangsgerät wesentlichen Abstimmstufen.

An eine Empfangsantenne 1 sind in dem dargestellten Ausführungsbeispiel zwei Abstimmeinheiten 2, 3 parallel angeschlossen. Hierzu weisen die Abstimmeinheiten 2, 3 jeweils einen Koppelkondensator 21, 31 auf, dessen nicht mit der Empfangsantenne 1 verbundenes Ende über einen Schalter 22, 32 an Masse legbar ist. Der Verbindungspunkt zwischen Koppelkondensator 21, 31 und Schalter 22, 32 ist mit einem durch ein Abstimmsignal V_{T} steuerbaren ersten Abstimmkreis 23, 32 verbunden. Dessen Ausgangssignal gelangt über einen Vorverstärker 24, 34 auf einen zweiten, durch das Abstimmsignal V_{T} abstimmbaren Abstimmkreis 25, 35. Die Ausgänge der beiden zweiten Bandpässe 25, 35 sind mit zwei Kontakten eines Umschalters 4 verbunden, dessen Ausgangskontakt einen Eingang einer als integrierte Schaltung ausgebildeten Frequenzumsetzerstufe 5 bildet.

Die Frequenzumsetzerstufe 5 weist eine Mischstufe 51 auf, an deren Ausgang die definierte Zwischenfrequenz ZF ansteht, die für den hier dargestellten UKW-Empfang bei 10,7 MHz liegt. Ein zweiter Eingang der Mischstufe 51 wird mit einem Oszillatorsignal versorgt, das durch eine in der Frequenzumsetzerstufe 5 integrierten Oszillatorstufe 52 und einen extern angeschalteten frequenzbestimmenden Oszillatorkreis 6 erzeugt wird. Der Oszillatorkreis 6 besteht in an sich bekannter Weise aus einer Oszillatorspule 7 mit zwei Teilwicklungen 71, 72, an deren Verbindungspunkt eine Anzapfung 73 vorgestehen ist, die parallel zu der Teilwicklung 72 mit einem Schalter 74 an Masse legbar ist.

Parallel zu der Oszillatorspule 7 ist eine Oszillatorkapazität 8 gegen Masse geschaltet, die in bekannter Weise aus zwei antiparallel geschalteten Kapazitätsdioden 81, 82 besteht. Dem Verbindungspunkt der beiden Kapazitätsdioden 81, 82 ist die Abstimmspannung V_{T} zuführbar, durch die die Kapazität der Kapazitätsdioden 81, 82, und damit die Frequenz des Oszillators 6, verstellbar ist.

Die Abstimmspannung V_{T} wird in an sich bekannter Weise mit Hilfe einer Phase-Locked-Loop (PLL) 53 erzeugt, in der das Abstimmsignal V_{T} über einen steuerbaren Frequenzteiler 54 steuerbar ist, dem das Ausgangssignal des Oszillators am Ausgang der verstärkenden Oszillatorstufe 52 über einen Trennverstärker 55 zugeführt wird. Die Einstellung des Frequenzteilers 54 wird in an sich bekannter Weise zum Zwecke der Abstimmung durch einen (nicht dargestellten) Mikroprozessor über einen Steuerbus 56 gesteuert.

Das in der Frequenzumsetzerstufe 5 erzeugte Zwischenfrequenzsignal ZF wird in hinreichend bekannter Weise im Rundfunkempfangsgerät weiterverarbeitet und in eine durch einen Lautsprecher, Kopfhörer o.dgl. wiedergebbare Niederfrequenz umgesetzt.

Die dargestellte Zeichnung zeigt die Stellungen der Schalter 22, 32, 4, 74 für die Wirksamschaltung der ersten Abstimmeinheit 2. Die Empfangsantenne 1 ist dabei wegen des geöffneten Schalters 22 über den Koppelkondensator 21 mit der wirksam geschalteten Abstimmeinheit 2 verbunden, wodurch die Einkopplung des empfangenen Signals in die Abstimmeinheit 2 erreicht wird. Der geschlossene Schalter 32 bewirkt dabei die Abschaltung und Entkopplung der zweiten Abstimmeinheit 3 von der Empfangsantenne 1.

Durch die Abstimmkreise 23, 25 findet eine übliche selektive Filterung statt, wobei die Mittenfrequenz der Abstimmkreise 23, 25 durch das Abstimmsignal V_{T} eingestellt wird. Das so selektierte Empfangssignal gelangt über den Umschalter 4, der am Ausgang des zweiten Abstimmkreises 25 geschlossen ist, in die Frequenzumsetzerstufe 5 und wird dort der Mischstufe 51 zugeführt. An dem zweiten Eingang der Mischstufe 51 wird das Oszillatorsignal des frequenzbestimmenden Oszillatorkreises 6 über die verstärkende Oszillatorstufe 52 zugeführt. Am Oszillatorkreis 6 ist durch den geschlossenen Schalter 74 nur die frequenz- und somit Empfangsbereich bestimmende Teilwicklung 71 aktiv. Innerhalb der Mischstufe 51 wird aus diesen beiden Signalen das Zwischenfrequenzstignal gebildet, welches den Weiterverarbeitungsstufen der Bildung eines hörbaren Niederfrequenzsignals dient.

In dem dargestellten Ausführungsbeispiel kann die erste Abstimmeinheit 2 beispielsweise für das in Europa verwendete UKW-Band zwischen 87,5 und 108 MHz ausgelegt sein.

Soll das erfindungsgemäße Rundfunkempfangsgerät nunmehr beispielsweise in Japan verwendet werden, wo das UKW-Band zwischen 76 und 90 MHz liegt, wird eine Umschaltung zur Wirksamschaltung der zweiten Abstimmeinheit 3 vorgenommen. Gegenüber der Darstellung in der Zeichnung sind hierfür die Schalter 22, 32, 4, 74 jeweils in die andere Position geschaltet, so daß die Empfangsantenne 1 nunmehr durch den Koppelkondensator 21 und den geschlossenen Schalter 22 von der ersten Abstimmeinheit 2 entkoppelt ist und das Empfangssignal aus der Empfangsantenne 1 über den Koppelkondensator 31 in der zweiten Abstimmeinheit 3 verarbeitet wird. Abgesehen davon, daß diese Abstimmeinheit 3 für den gewünschten Frequenzbereich, beispielsweise zwischen 76 und 90 MHz ausgelegt ist, findet die Verarbeitung in der gleichen Weise statt, wie oben für die erste Abstimmeinheit 2 beschrieben. Der nunmehr zum Ausgang des zweiten Abstimmkreises 35 hin geschlossene Umschalter 4 verbindet die zweite Abstimmeinheit 3 mit der Frequenzumsetzerstufe 5. Der geöffnete Schalter 74 bewirkt, daß in dem Oszillatorkreis 6 die aus der Serienschaltung der beiden Teilwicklungen 71, 72 gebildeten Gesamtspule 7 wirksam ist, woraus sich die benötigte Frequenzumschaltung ergibt.

Zur Bildung des Abstimmsignals V_{T} werden von dem (nicht dargestellten) Mikroprozessor die nunmehr zutreffenden Teilerverhältnisse über den Steuerbus 56 am Frequenzteiler 54 eingestellt.

Vorzugsweise wird die Umschaltung des Oszillatorkreises 6 so durchgeführt, daß er für den Empfangs-Frequenzbereich der ersten Abstimmeinheit (87,5 bis 108 MHz) zwischen etwa 98 und 119 MHz durchstimmbar ist, um die Zwischenfrequenz von 10,7 MHz zu erzeugen. Die Frequenz des Oszillatorkreises 6 liegt in diesem Fall somit oberhalb der Frequenz der an der Empfangsantenne 1 empfangenen Signale.

Für das Empfangsband der zweiten Empfangseinheit 3 (beispielsweise 76 bis 90 MHz) liegt die Durchstimmfrequenz des Oszillators demgegenüber vorzugsweise bei 64 bis 79 MHz, liegt also um 10,7 MHz unterhalb der Empfangsfrequenz.

Das beschriebene Ausführungsbeispiel ist für zwei unterschiedliche Empfangsbänder vorgesehen. Selbstverständlich ist es ohne weiteres möglich und sinnvoll, für drei oder mehr Empfangsbänder eine entsprechend höhere Anzahl von Abstimmeinheiten und ggfs. eine entsprechende Anzahl von Umschaltungen des Oszillatorkreises 6 vorzusehen.

## Patentansprüche

1. Rundfunkempfangsgerät mit mindestens zwei an eine Empfangsantenne (1) angeschlossenen, separat wirksam schaltbaren, durchstimmbaren Abstimmstufen (2, 3) für zwei Empfangsbereiche,
mit einem Umschalter (4) zur wahlweisen Verbindung einer der Abstimmstufen (2, 3) mit einer Frequenzumsetzerstufe (5) mit einem Mischoszillator (6) zur Umsetzung empfangener Hochfrequenzsignale in eine definierte Zwischenfrequenz, wobei der Mischoszillator (6) mit einer Umschaltung auf eine der Abstimmstufen (2, 3) in seinem Abstimmbereich derart umschaltbar ist, daß seine Schwingfrequenz für einen ersten Empfangsbereich der ersten Abstimmstufe (2) um eine Zwischenfrequenz oberhalb der zu empfangenden Frequenz und für einen zweiten Empfangsbereich der zweiten Abstimmstufe (3) um die Zwischenfrequenz unterhalb der zu empfangenden Frequenz eingestellt wird.

2. Rundfunkempfänger nach Anspruch 1, **dadurch gekennzeichnet, daß** der Mischoszillator (6) mit einer mit einer Anzapfung (73) versehenen Oszillatorspule (7) gebildet ist, und daß der Mischoszillator (6) durch eine Wirksamschaltung oder Unwirksamschaltung (74) der Anzapfung (73) umschaltbar ist.

3. Rundfunkempfangsgerät nach Anspruch 1 oder 2, **dadurch gekennzeichnet, daß** die Empfangsantenne (1) jeweils über einen Koppelkondensator (21, 31) und einen Schalter (22, 32) nur für die über den Umschalter (4) mit der Frequenzumsetzerstufe (5) verbundene Abstimmstufe (2, 3) wirksam schaltbar ist.

4. Rundfunkempfangsgerät nach einem der vorhergehenden Ansprüche, **dadurch gekennzeichnet, daß** die Abstimmstufen (2, 3) jeweils einen ersten durchstimmbaren Abstimmkreis (23, 33), eine Verstarkerstufe (24, 34) und einen zweiten durchstimmbaren Abstimmkreis (25, 35) aufweisen.

5. Rundfunkempfangsgerät nach einem der vorhergehenden Ansprüche, **dadurch gekennzeichnet, daß** die Frequenzumsetzerstufe (5) eine Mischstufe (51), eine Oszillator-Verstärkerstufe (52), einen Trennverstärker (55), einen über einen Datenbus programmierbaren Teiler (54) und eine PLL-Stufe (53) aufweist.

## Claims

1. Broadcast radio receiver having at least two tuneable tuning stages (2, 3), which are connected to a reception antenna (1) and can be activated separately, for two reception ranges,
having a changeover switch (4) for selectively connecting one of the tuning stages (2, 3) to a frequency converter stage (5) having a mixing oscillator (6) for converting received radio-frequency signals into a defined intermediate frequency, where the tuning range of the mixing oscillator (6) can be changed over, by changing over to one of the tuning stages (2, 3), such that the frequency of oscillation of said mixing oscillator is set around an intermediate frequency above the frequency to be received for a first reception range of the first tuning stage (2) and is set around the intermediate frequency below the frequency to be received for a second reception range of the second tuning stage (3).

2. Broadcast radio receiver according to Claim 1, **characterized in that** the mixing oscillator (6) is formed using an oscillator coil (7) provided with a tap (73), and **in that** the mixing oscillator (6) can be changed over by activating or deactivating (74) the tap (73).

3. Broadcast radio receiver according to Claim 1 or 2, **characterized in that** the reception antenna (1) can respectively be activated using a coupling capacitor (21, 31) and a switch (22, 32) only for the tuning stage (2, 3) which is connected to the frequency converter stage (5) via the changeover switch (4).

4. Broadcast radio receiver according to one of the preceding claims, **characterized in that** the tuning stages (2, 3) respectively have a first tuneable tuning circuit (23, 33), an amplifier stage (24, 34) and a second tuneable tuning circuit (25, 35).

5. Broadcast radio receiver according to one of the preceding claims, **characterized in that** the frequency converter stage (5) has a mixing stage (51), an oscillator amplifier stage (52), an isolating amplifier (55), a divider (54) which can be programmed via a data bus, and a PLL stage (53).

## Revendications

1. Appareil récepteur radio comportant au moins une antenne de réception (1) à laquelle sont reliés des étages d'accord (2, 3) commutables séparément à l'état actif, et qui peuvent être accordés pour deux plages de réception, et un commutateur (4) pour relier sélectivement l'un des étages d'accord (2, 3) à un étage convertisseur de fréquence (5) ayant un oscillateur mélangeur (6) pour convertir les signaux de fréquence reçus en des signaux de fréquence intermédiaires, déterminés,
dans lequel l'oscillateur mélangeur (6) peut être commuté par un moyen de commutation sur l'un des étages d'accord (2, 3) dans sa plage d'accord de façon que sa fréquence d'oscillation pour une première plage de réception du premier étage d'accord (2) soit située au-dessus d'une fréquence de réception de la différence de la fréquence intermédiaire et que pour une seconde plage de réception du second étage d'accord (3), le réglage se fait en dessous de la fréquence de réception de la différence correspondant à la fréquence intermédiaire.

2. Appareil récepteur radio selon la revendication 1,
**caractérisé en ce que**
l'oscillateur mélangeur (6) comporte une bobine d'oscillateur (7) munie d'une prise (73) et l'oscillateur mélangeur (6) peut être commuté par la mise en oeuvre ou la neutralisation (74) de la prise (73).

3. Appareil récepteur radio selon la revendication 1 ou 2,
**caractérisé en ce que**
par un condensateur de couplage (21, 31) de l'interrupteur (22,32) l'antenne de la réception (1) est reliée uniquement à l'étage d'accord (2, 3) relié à l'étage convertisseur de fréquence (5) par le commutateur (4).

4. Appareil récepteur radio selon l'une des revendications précédentes,
**caractérisé en ce que**
les étages d'accord (2, 3) comportent chacun un premier circuit d'accord (23, 33) accordable, un étage amplificateur (24, 34) et un second circuit d'accord (25, 35) accordable.

5. Appareil récepteur radio selon l'une des revendications précédentes,
**caractérisé en ce que** l'étage convertisseur de fréquence (5) comporte un étage mélangeur (51), un étage amplificateur oscillateur (52), un amplificateur séparateur (55), un diviseur (54) programmable par l'intermédiaire d'un bus de données et une boucle en phase (circuit PLL) (53).
